# EUROPÄISCHE PATENTSCHRIFT

(11) **EP 4 584 828 B1**
(45) Veröffentlichungstag und Bekanntmachung des Hinweises auf die Patenterteilung: **25.03.2026**
(21) Anmeldenummer: 23758599.7
(22) Anmeldetag: 17.08.2023
(51) Int. Cl.: H01M 4/04, H01M 10/052, H01M 10/0525

(54) **VERFAHREN ZUR HERSTELLUNG EINER ELEKTRODE, ELEKTRODE, ALKALI-BATTERIE UND VERWENDUNGEN DER ALKALI-BATTERIE**
METHOD OF MANUFACTURING AN ELECTRODE, ELECTRODE, ALKALI BATTERY AND USE OF THE ALKALI BATTERY
MÉTHODE DE FABRICATION D'UNE ÉLECTRODE, ÉLECTRODE, PILE ALCALINE ET UTILISATION DE LA PILE ALCALINE

(30) Priorität: 08.09.2022 DE 102022209362
(43) Veröffentlichungstag der Anmeldung: 16.07.2025
(73) Patentinhaber: Fraunhofer-Gesellschaft zur Förderung der angewandten Forschung e.V., 80686 München (DE)
(72) Erfinder: BIRKE, Kai Peter, 70569 Stuttgart (DE); SCHAD, Kathrin, 70569 Stuttgart (DE); WEEBER, Max, 70569 Stuttgart (DE)
(74) Vertreter: Pfenning, Meinig & Partner mbB
(86) Internationale Anmeldenummer: PCT/EP2023/072722
(87) Internationale Veröffentlichungsnummer: WO 2024/052076

(56) Entgegenhaltungen:
- CN-A- 112 670 673
- FR-A1- 3 110 775
- US-A1- 2017 033 348
- US-A1- 2019 288 277

## Beschreibung

Es werden ein Verfahren zur Herstellung einer Elektrode für eine galvanische Zelle, eine Elektrode für eine galvanische Zelle, eine galvanische Zelle und Verwendungen der galvanischen Zelle vorgestellt. Das Verfahren umfasst ein Aufbringen einer Separatormembran auf eine flächige Elektrode, sodass sich zwischen der flächige Elektrode und der Separatormembran ein Zwischenraum ausbildet, ein anschließendes Aufbringen einer Flüssigkeit mit einem bestimmten Material auf die Separatormembran, wobei die Flüssigkeit mit Material über Kapillarkräfte zumindest Poren der Separatormembran, in den Zwischenraum zwischen der flächigen Elektrode und der Separatormembran und in Poren der flächigen Elektrode vordringt, wobei die Flüssigkeit im Anschluss verdampft wird. Mit dem Verfahren ist es auf einfache und kostengünstige Art und Weise möglich, eine Elektrode bereitzustellen, die eine hohe Energiedichte auf Zellebene sowie eine hohe chemische, elektrochemische und mechanische Stabilität aufweist und auf diese Weise eine hohe Zykelstabilität aufweist und hohe Betriebsströme ermöglicht.

Kommerziell Alkali-Batterien (z.B. Lithium-Ionen-Batterien mit einer Graphitanode) sind materialbedingt an einem Limit bezüglich der möglichen Energiedichte angelangt. Zusätzlich zu den steigenden Leistungsanforderungen sorgen hohe prozess- und lieferbedingte Materialkosten für die Notwendigkeit alternativer Anodenansätze.

Zur Verbesserung der Energiedichte von galvanischen Zellen wurde in der Literatur vorgeschlagen, anstelle einer kommerziellen Graphit-basierten negativen Elektrode (Anode) Lithiummetall, Lithium-Metalllegierungen oder Natrium-Metalllegierungen zu verwenden (z.B. eine LiAl-Legierung oder eine NaAl-Legierung). Die Verwendung von reinem metallischem Lithium bzw. von Metalllegierungen führt jedoch zu einer unzureichende Zykelfestigkeit und ist mit hohen Herstellungs- und Materialkosten verbunden. Für die Zugänglichkeit und Stabilisierung dieser vielversprechenden hochkapazitiven Elektrodenmaterialien sind daher Vorbehandlungsmaßnahmen an der Elektroden-Elektrolyt-Grenzfläche unumgänglich.

Die CN 112670673 A offenbart einen Separator, der mit einer Aktivschicht beschichtet wurde, wobei die Aktivschicht einen organischen Binder und anorganische Partikel und ein Lithium-Leitsalz enthält. Zur Herstellung einer Elektrode wird der fertige Separator auf ein leitfähiges Substrat aufgebracht, wobei hierbei eine Elektrode entsteht, deren mechanische Stabilität und möglichen Betriebsströme bzw. erreichbare Energiedichte weiter verbessert werden könnten. Durch den Einsatz von anorganischen Partikeln, insbesondere im Falle der Verwendung einer Lithiumfolie als leitfähiges Substrat, gestaltet sich die Herstellung der Elektrode als aufwändig und kostenintensiv.

Ausgehend hiervon war es die Aufgabe der vorliegenden Erfindung, ein Verfahren zur Herstellung einer Elektrode für eine galvanische Zelle, eine Elektrode für eine für eine galvanische Zelle und eine galvanische Zelle bereitzustellen, welche die Nachteile aus dem Stand der Technik nicht aufweist. Insbesondere sollte das Verfahren einfach sein und auf kostengünstige Art und Weise eine Elektrode bereitstellen, die bei ihrer Verwendung in einer galvanischen Zelle eine hohe Energiedichte auf Zellebene, eine hohe chemische, elektrochemische und mechanische Stabilität aufweist und auf diese Weise eine hohe Zykelstabilität aufweist und hohe Betriebsströme ermöglicht. Ferner sollten Verwendungen der galvanischen Zelle vorgeschlagen werden.

Die Aufgabe wird gelöst durch das Verfahren mit den Merkmalen von Anspruch 1, die Elektrode mit den Merkmalen von Anspruch 10, die galvanische Zelle mit den Merkmalen von Anspruch 17 und die Verwendung mit den Merkmalen von Anspruch 18. Die abhängigen Ansprüche zeigen vorteilhafte Weiterbildungen auf.

Erfindungsgemäß wird ein Verfahren zur Herstellung einer Elektrode für eine galvanische Zelle bereitgestellt, umfassend
a) Bereitstellen einer flächigen Elektrode, wobei die flächige Elektrode eine Oberfläche aufweist;
b) Aufbringen einer ersten Oberfläche einer Separatormembran auf die Oberfläche der flächigen Elektrode, sodass sich zwischen der Oberfläche der flächigen Elektrode und der ersten Oberfläche der Separatormembran ein Zwischenraum ausbildet;
c) Aufbringen einer Flüssigkeit auf eine zweite Oberfläche der Separatormembran, die der ersten Oberfläche gegenüberliegt, wobei die Flüssigkeit ein Lösungsmittel und ein Material enthält, das ausgewählt ist aus der Gruppe bestehend aus Polymer, anorganische Partikel, organische Partikel und Kombinationen hiervon, wobei die Flüssigkeit mit ihrem Lösungsmittel und ihrem Material über Kapillarkräfte zumindest in die Poren der Separatormembran, in den Zwischenraum zwischen der Oberfläche der Elektrode und der ersten Oberfläche der Separatormembran und in Poren der Oberfläche der flächigen Elektrode vordringt; und
d) Verdampfen des Lösungsmittels der Flüssigkeit, wobei eine Elektrode entsteht, die das Material der Flüssigkeit in dem Zwischenraum zwischen der Oberfläche der Elektrode und der ersten Oberfläche der Separatormembran enthält und in zumindest in einem Teil der Poren enthält, wobei das Material die Oberfläche der Elektrode und die erste Oberfläche der Separatormembran flächig kontaktiert.

Das erfindungsgemäße Verfahren lässt sich auf einfache und kostengünstige Art und Weise durchführen. Ferner lässt sich über das erfindungsgemäße Verfahren eine Elektrode herstellen, die eine hohe Energiedichte auf Zellebene aufweist, eine hohe chemische, elektrochemische und mechanische Stabilität aufweist und auf diese Weise eine hohe Zykelstabilität aufweist und hohe Betriebsströme ermöglicht. Grund hierfür ist, dass nach dem Verdampfen der Flüssigkeit das Material der Flüssigkeit in den Poren der Separatormembran, in dem Zwischenraum zwischen der Oberfläche der Elektrode und der ersten Oberfläche der Separatormembran und in die Poren der Oberfläche der flächigen Elektrode vorliegt. Durch dieses Vordringen des Materials der Flüssigkeit entsteht eine angereicherte Materialschicht in den Poren der Separatormembran, im Zwischenraum und in den Poren der flächigen Elektrode. Diese angereicherte Materialschicht sorgt bei der Zugabe eines Flüssigelektrolyts, durch die Ausbildung eines Konzentrationsgradienten, für eine optimale Elektrolytverteilung an der Grenzfläche und in den Poren der flächigen Elektrode. Zusätzlich stellt die angereicherte Materialschicht eine poröse Stützstruktur dar, die die Ausbildung einer immobilisierten, stabilen Schutzschicht (Solid electrolyte interface, SEI) zwischen Elektrolyt und Elektodenoberfläche begünstigt. Ferner vermittelt das Material der Materialschicht eine starke Adhäsion von der Separatormembran an die flächige Elektrode. Die genannten Aspekte verschaffen der Elektrode eine hohe Zykelstabilität, wodurch stabilitätskritische Elektrodenmaterialien (wie z.B. eine LiAl-Legierung) mit hoher spezifischer Kapazität verwendet werden können. Auf diese Weise sind hohe Energiedichten auf Zellebene realisierbar.

Das Material kann dazu geeignet sein, mit einem Flüssigelektrolyt zu einem Gel zu quellen. Dies führt zu einer verbesserten Elektroylverteilung und damit lonenleitung an der Oberfläche der flächigen Elektrode. Da das Material auch in den Poren der Separatormembran und in den Poren der Oberfläche der flächigen Elektrode vorliegt, liegt der Flüssigelektrolyt nach dem Quellvorgang auch in den Poren der Separatormembran und der Oberfläche der flächigen Elektrode vor, was zu einem verbesserten Ionentransport von der zweiten Oberfläche der Separatormembran bis zur Oberfläche der flächigen Elektrode führt, was die Energiedichte gegenüber bekannten Elektroden für galvanische Zellen erhöht. Nach einer Quellung des Materials mit dem Flüssigelektrolyten bildet sich in dem Zwischenraum zwischen Separatormembran und flächiger Elektrode und in den Poren der Separatormembran und der Oberfläche der Elektrode ein sog. "solid electrolyte interface" (kurz: SEI), das an den jeweiligen Oberflächen stark fixiert und immobilisiert ist. Die sich ergebende stabile Schutzschicht sorgt für die Erhöhung der chemischen und elektrochemischen Stabilität der Elektrode und stellt eine mechanische Barriere dar welche potenzielles Dendritenwachstum verlangsamt. Die Elektrode weist damit eine höhere Zykelfestigkeit und Betriebssicherheit gegenüber vergleichbaren Elektroden für galvanische Zellen auf.

Die in dem Verfahren verwendete flächige Elektrode kann ein Alkalimetall, optional auf ein Metall ausgewählt aus der Gruppe bestehend aus Edelstahl, Nickel, Kupfer, Indium, Aluminium und Kombinationen hiervon beschichtet, enthalten oder daraus bestehen. Das Alkalimetall ist bevorzugt ausgewählt aus der Gruppe bestehend aus Lithium, Natrium und Kombinationen hiervon. Der Vorteil von Lithium ist seine hohe spezifische Kapazität von > 3000 Ah/kg (10-facher Wert von kommerziellen Graphitanoden), sein geringes Anodenpotenzial von 0 V vs. Li/Li⁺ und die daraus resultierende sehr hohe Energiedichte auf Zellebene.

Die in dem Verfahren verwendete flächige Elektrode kann ferner Kohlenstoff enthalten oder daraus bestehen, bevorzugt einen Kohlenstoff, der ausgewählt ist aus der Gruppe bestehend aus Graphit, Graphen und Kombinationen hiervon.

Abgesehen davon kann die in dem Verfahren verwendete flächige Elektrode Silizium, eine Siliziumlegierung und/oder ein Siliziumkomposit enthalten oder daraus bestehen.

Darüber hinaus kann die in dem Verfahren verwendete flächige Elektrode ein Metall ausgewählt aus der Gruppe bestehend aus Edelstahl, Nickel, Kupfer, Indium, Aluminium, bevorzugt Aluminium, enthalten oder daraus bestehen. Ein Vorteil von Aluminium liegt darin, dass es kostengünstiger ist als andere passende Legierungsbildner wie Indium oder Silizium. Weitere Vorteile von Aluminium liegen in seinem niedrigen Anodenpotenzial (U_anode), das bei einer LiAl-Legierung bei ca. 0,3 V vs Li/Li⁺(vergleichbar mit der Potenziallage der kommerziell verwendeten Graphitanode) liegt und für die Maximierung der Zellspannung U = U_kathode - U_anode führt. Ferner kann Aluminium eine hohe spezifische Kapazität bereitstellen (z.B. in der Legierungsform LiAl ca. 993 Ah/kg, was etwa dem dreifachen von Graphit entspricht). Auf diese Weise ist die bereitstellbare Energiedichte E auf Zellebene (E = C * U) im Falle einer aluminiumbasierten Anode sehr hoch. Das Aluminium ist optional legiert, bevorzugt mit mindestens einem Element ausgewählt aus der II. Hauptgruppe des Periodensystems, der III. Hauptgruppe des Periodensystems, der IV. Hauptgruppe des Periodensystems, einer Nebengruppe des Periodensystems und Kombinationen hiervon, wobei das mindestens eine Element bevorzugt ausgewählt ist aus der Gruppe bestehend aus Magnesium, Indium, Zink, Zinn, Silizium, Mangan und Kombinationen hiervon.

Die in dem Verfahren verwendete flächige Elektrode kann ferner ein Kathodenmaterial enthalten oder daraus bestehen, das bevorzugt ausgewählt ist aus der Gruppe bestehend aus Nickel-Mangan-Kobaltoxid, Lithiumeisenphosphat, Lithium-Manganoxid, Lithium-Nickel-Manganoxid, Lithium-Nickeloxid, Lithium-Kobaltoxid, Lithium-Aluminium-Nickeloxid, Lithiummanganphosphat, Lithiumeisenmanganphosphat und Kombinationen hiervon.

Die flächige Elektrode, die in dem Verfahren verwendet wird, kann eine Dicke, in einer Richtung senkrecht auf die Oberfläche der flächigen Elektrode, im Bereich von 5 bis 100 µm, bevorzugt 10 bis 50 µm, besonders bevorzugt 20 bis 40 µm, aufweisen.

Ferner kann die in dem Verfahren verwendete flächige Elektrode auf ihrer Oberfläche eine Oberflächenstrukturierung aufweisen. Die Oberflächenstrukturierung weist bevorzugt eine Strukturtiefe im Bereich von 1 nm bis 100 µm auf, wobei die Oberflächenstrukturierung besonders bevorzugt ausgewählt ist aus der Gruppe bestehend aus geprägte Oberflächenstrukturierung, gebürstete Oberflächenstrukturierung, gemusterte Oberflächenstrukturierung, geriffelte Oberflächenstrukturierung und Kombinationen hiervon.

Die in dem Verfahren verwendete Separatormembran kann aus einer mindestens einer Lage, optional auch mindestens einer weiteren Lage (d.h. mindestens zwei Lagen) bestehen.

Die mindestens eine Lage (optional auch mindestens eine weitere Lage) kann ein elektrisch isolierendes Material enthalten oder daraus bestehen, wobei das Material bevorzugt einen spezifischen elektrischen Widerstand von ≥ 10¹⁰ Ω·mm²/m, besonders bevorzugt ≥ 10¹¹ Ω·mm²/m, aufweist.

Ferner kann die mindestens eine Lage (optional auch mindestens eine weitere Lage) ein organisches Material enthalten oder daraus bestehen, bevorzugt einen polymeren Kunststoff enthalten oder daraus bestehen. Der polymere Kunststoff ist besonders bevorzugt ausgewählt ist aus der Gruppe bestehend aus Polyolefin, Fluorpolymer, Polyamid, Polyimid und Kombinationen hiervon, wobei der polymere Kunststoff insbesondere ausgewählt ist aus der Gruppe bestehend aus Polyethylen, Polypropylen, Polytetrafluorethylen, Polyamid, Para-Aramid, Polyimid und Kombinationen hiervon.

Darüber hinaus kann die mindestens eine Lage (optional auch mindestens eine weitere Lage) ein anorganisches Material enthalten oder daraus bestehen, bevorzugt ein keramisches Material enthalten oder daraus bestehen. Das keramische Material ist insbesondere ausgewählt ist aus der Gruppe bestehend aus Oxid-Keramik, Carbid-Keramik, Nitrid-Keramik und Phosphat-Keramik. Bei der Oxid-Keramik kann es sich um Aluminiumoxid (Al₂O₃) handeln. Al₂O₃ hat den Vorteil, dass es kostengünstig im Vergleich zu Festelektrolytsalzen wie Lithiumphosphorsulfid ist. Ferner bildet Al₂O₃ eine inerte Schutzschicht und damit keine unerwünschten Nebenreaktionen. Zudem stellt Al₂O₃ (in Form von Partikeln) eine poröse Struktur bereit, was die Elektrolytverteilung verbessert und einen SEI-Precursor-Effekt bewirkt.

Abgesehen davon kann die mindestens eine Lage (optional auch mindestens eine weitere Lage) ein ionenleitfähiges Material enthalten oder daraus bestehen.

Ferner kann die mindestens eine Lage (optional auch mindestens eine weitere Lage) eine Dicke, in einer Richtung senkrecht auf die Oberfläche der flächigen Elektrode, im Bereich von 1 µm bis 300 µm, bevorzugt im Bereich von 1 µm bis 100 µm, aufweisen.

Zudem kann die mindestens eine Lage (optional auch mindestens eine weitere Lage) eine Porosität im Bereich von 30% bis 70%, bevorzugt im Bereich von 40% bis 60%, besonders bevorzugt im Bereich von 45% bis 50 % aufweisen.

Die in dem Verfahren verwendete Flüssigkeit kann ein Lösungsmittel enthalten, das bei Atmosphärendruck einen Siedepunkt von ≤ 156 °C, bevorzugt ≤ 80 °C, besonders bevorzugt ≤ 56 °C, aufweist. Ferner kann die in dem Verfahren verwendete Flüssigkeit ein Lösungsmittel enthalten, das bei 20 °C einen Dampfdruck von ≥ 3 hPa, bevorzugt ≥ 58 hPa, besonders bevorzugt ≥ 246 hPa, aufweist. Das Lösungsmittel kann ausgewählt sein aus der Gruppe bestehend aus Aceton, DEC, DMAC, 3-Hexanon, THF, Butanon, 3-Pentanone, Toluol, p-Xylene, Ethanol und Mischungen hiervon, wobei das Lösungsmittel insbesondere Aceton ist. Vorteil von einem Lösungsmittel mit einem niedrigen Siedepunkt bzw. einem hohen Dampfdruck ist, dass das Verfahren weniger energieintensiv ist, d.h. ökonomischer durchgeführt werden kann.

Das in dem Verfahren verwendete Material der Flüssigkeit kann ein Polymer enthalten oder daraus bestehen, das in dem Lösungsmittel gelöst ist.

Das Polymer kann ein nicht-ionenleitendes Polymer und/oder ein ionenleitendes Polymer enthalten oder daraus bestehen. Beispielsweise kann das Polymer ein Fluorpolymer und/oder ein Polyethylenoxid enthalten oder daraus bestehen, wobei das Fluorpolymer bevorzugt ausgewählt ist aus der Gruppe bestehend aus PVDF-HFP, PVDF und Kombinationen hiervon. Der Vorteil von PVDF-HFP ist, dass es sich sehr gut in Aceton löst und ein Netzpolymer ausbildet, d.h. eine Stützmatrix, die eine verbesserte Elektrolytverteilung bewirkt und als Fixateur für ein SEI dient.

Das Polymer kann in einer Konzentration von 60 Gew.-% bis 80 Gew.-%, bevorzugt 65 Gew.-% bis 75 Gew.-%, insbesondere 70 Gew.-%, in Bezug auf das Gesamtgewicht der Flüssigkeit, in der Flüssigkeit vorliegen.

Das in dem Verfahren eingesetzte Material der Flüssigkeit kann anorganische Partikel enthalten oder daraus bestehen, die in dem Lösungsmittel dispergiert sind.

Die anorganischen Partikel können nicht-elektrisch-leitende anorganische Partikel, besonders bevorzugt nicht-elektrisch-leitende keramische Partikel, sein.

Die Partikel können ferner ionenleitende anorganische Partikel sein, besonders bevorzugt ionenleitende anorganische Partikel, die ein sulfidisches Salz enthalten oder daraus bestehen, wobei das sulfidische Salz insbesondere ausgewählt ist aus der Gruppe bestehend aus Lithiumphosphorsulfid (Li₃PS₄), Lithium-Germanium-Phosphorsulfid (Li₁₀GeP₂S₁₂), Lithium-Silizium-Phosphorsulfid (Li₁₁Si₂PS₁₂), Li₆PS₅Cl, Li₆PS₅Br und Kombinationen hiervon. Der Vorteil von sulfidische Salzen ist, dass eine hohe, mit kommerziellen Flüssigelektrolyten konkurrierbare, ionische Leitfähigkeit erreicht wird.

In dem Verfahren kann das Verdampfen des Lösungsmittels der Flüssigkeit bei einer Temperatur im Bereich von 20 bis 30 °C, bevorzugt bei 25 °C, erfolgen. Dies ist besonders energieschonend, da das Verdampfen bei Umgebungstemperatur erfolgen kann und für die Verdampfung keine zusätzliche Wärmeenergie zugeführt werden muss.

Das Verfahren kann nach Schritt d) ferner ein Aufbringen eines Flüssigelektrolyten für eine galvanische Zelle auf die zweite Oberfläche der Separatormembran umfassen, wobei der Flüssigelektrolyt über Kapillarkräfte zumindest in einem Teil der Poren der Separatormembran, in den Zwischenraum zwischen der Oberfläche der flächige Elektrode und der ersten Oberfläche der Separatormembran und in die Poren der Oberfläche der flächigen Elektrode vordringt, wobei der Flüssigelektrolyt insbesondere die Oberfläche der flächige Elektrode und die erste Oberfläche der Separatormembran kontaktiert.

Der hierfür verwendete Flüssigelektrolyt kann eine Flüssigkeit enthalten, die ausgewählt ist aus der Gruppe bestehend aus EC, PC, DMC, EMC, DEC, VEC, VC, FEC, TBAC (Acetyltributylcitrat), GTB (Glycerintributyrat), GTA (Glycerintriacetat), y-Buthyrolacton und Kombinatonen hiervon, wobei die Flüssigkeit bevorzugt ausgewählt ist aus der Gruppe bestehend aus PC, FEC, EC, VEC, TBAC, GTB, GTA und Kombinationen hiervon. Der Vorteil von PC, FEC, EC, VEC, TBAC, GTB, GTA liegt in ihrem hohen Siedepunkt und Temperaturbeständigkeit, was die Brandgefahr herabsetzt und die Betriebssicherheit erhöht.

Ferner kann der hierfür verwendete Flüssigelektrolyt ein Lithium-Leitsalz enthalten, wobei das Lithium-Leitsalz bevorzugt ausgewählt ist aus der Gruppe bestehend aus LiPF₆, LiClO₄, LiNO₃, C₆H₁₈LiNSi₂, F₂LiNO₄S₂, C₂F₆LiNO₄S₂, LiB[C₂O₄]₂, LiBF₄ und Kombinationen hiervon.

Abgesehen davon kann der hierfür verwendete Flüssigelektrolyt ein Natrium-Leitsalz enthalten, wobei das Natrium-Leitsalz bevorzugt ausgewählt ist aus der Gruppe bestehend aus NaPF₆, NaBF₄, NaTF, NaTFSI, NaClO₄ und Kombinationen hiervon.

Ferner wird erfindungsgemäß eine Elektrode für eine galvanische Zelle bereitgestellt, enthaltend oder bestehend aus
a) eine flächige Elektrode, wobei die flächige Elektrode eine Oberfläche aufweist;
b) eine Separatormembran, die eine erste Oberfläche aufweist, eine zweite Oberfläche, die der ersten Oberfläche gegenüberliegt, aufweist, und Poren aufweist, wobei die erste Oberfläche der Separatormembran auf der Oberfläche der flächigen Elektrode aufgebracht ist, und zwischen der Oberfläche der flächigen Elektrode und der ersten Oberfläche der Separatormembran ein Zwischenraum besteht; und
c) mindestens ein Material, das ausgewählt ist aus der Gruppe bestehend aus Polymer, anorganische Partikel, organische Partikel und Kombinationen hiervon, wobei das Material zumindest in einem Teil der Poren der Separatormembran angeordnet ist, in dem Zwischenraum zwischen der Oberfläche der flächige Elektrode und der ersten Oberfläche der Separatormembran angeordnet ist und in Poren der Oberfläche der flächigen Elektrode angeordnet ist, und wobei das Material die erste Oberfläche der Separatormembran und die Oberfläche der flächige Elektrode flächig kontaktiert.

Die erfindungsgemäße Elektrode weist eine hohe Energiedichte auf Zellebene sowie eine hohe chemische, elektrochemische und mechanische Stabilität auf.

Folglich weist die erfindungsgemäße Elektrode eine hohe Zykelstabilität und ermöglicht hohe Betriebsströme.

Die flächige Elektrode kann ein Alkalimetall, optional auf ein Metall ausgewählt aus der Gruppe bestehend aus Edelstahl, Nickel, Kupfer, Indium, Aluminium und Kombinationen hiervon beschichtet, enthalten oder daraus bestehen. Das Alkalimetall ist bevorzugt ausgewählt ist aus der Gruppe bestehend aus Lithium, Natrium und Kombinationen hiervon. Der Vorteil von Lithium ist seine hohe spezifische Kapazität von > 3000 Ah/kg (10-facher Wert von kommerziellen Graphitanoden), sein geringes Anodenpotenzial von 0 V vs. Li/Li⁺ und seine sehr hohe Energiedichte.

Ferner kann die flächige Elektrode Kohlenstoff enthalten oder daraus bestehen, bevorzugt einen Kohlenstoff, der ausgewählt ist aus der Gruppe bestehend aus Graphit, Graphen und Kombinationen hiervon.

Zudem kann die flächige Elektrode Silizium, eine Siliziumlegierung und/oder ein Siliziumkomposit enthalten oder daraus bestehen.

Abgesehen davon kann die flächige Elektrode ein Metall ausgewählt aus der Gruppe bestehend aus Edelstahl, Nickel, Kupfer, Indium, Aluminium, bevorzugt Aluminium enthalten oder daraus bestehen. Ein Vorteil von Aluminium liegt darin, dass es kostengünstiger ist als andere passende Legierungsbildner wie Indium oder Silizium. Weitere Vorteile von Aluminium liegen in seinem niedrigen Anodenpotenzial U, das bei einer LiAl-Legierung bei ca. 0,3 V vs Li/Li⁺(vergleichbar mit Graphit) liegt. Ferner kann Aluminium eine hohe spezifische Kapazität C bereitstellen (C einer LiAl ist ca. 993 Ah/kg, was etwa dem dreifachen von Graphit entspricht). Zudem ist die bereitstellbare Energiedichte E = C * U im Falle von Aluminium sehr hoch. Das Aluminium kann legiert sein, bevorzugt mit mindestens einem Element ausgewählt aus der II. Hauptgruppe des Periodensystems, der III. Hauptgruppe des Periodensystems, der IV. Hauptgruppe des Periodensystems, einer Nebengruppe des Periodensystems und Kombinationen hiervon, wobei das mindestens eine Element bevorzugt ausgewählt ist aus der Gruppe bestehend aus Magnesium, Indium, Zink, Zinn, Silizium, Mangan und Kombinationen hiervon.

Darüber hinaus kann die flächige Elektrode ein Kathodenmaterial enthalten oder daraus bestehen, das bevorzugt ausgewählt ist aus der Gruppe bestehend aus Nickel-Mangan-Kobaltoxid, Lithiumeisenphosphat, Lithium-Manganoxid, Lithium-Nickel-Manganoxid, Lithium-Nickeloxid, Lithium-Kobaltoxid, Lithium-Aluminium-Nickeloxid, Lithiummanganphosphat, Lithiumeisenmanganphosphat und Kombinationen hiervon.

Die flächige Elektrode kann eine Dicke, in einer Richtung senkrecht auf die Oberfläche der flächigen Elektrode, im Bereich von 5 bis 100 µm, bevorzugt 10 bis 50 µm, besonders bevorzugt 20 bis 40 µm, aufweisen.

Ferner kann die flächige Elektrode auf ihrer Oberfläche eine Oberflächenstrukturierung aufweisen. Die Oberflächenstrukturierung weist bevorzugt eine Strukturtiefe im Bereich von 1 nm bis 100 µm auf, wobei die Oberflächenstrukturierung besonders bevorzugt ausgewählt ist aus der Gruppe bestehend aus geprägte Oberflächenstrukturierung, gebürstete Oberflächenstrukturierung, geriffelte Oberflächenstrukturierung, gemusterte Oberflächenstrukturierung, und Kombinationen hiervon.

Die Separatormembran kann aus einer mindestens einer Lage, optional auch mindestens einer weiteren Lage (d.h. aus mindestens zwei Lagen), bestehen.

Die mindestens eine Lage, optional auch die mindestens eine weitere Lage, kann ein elektrisch isolierendes Material enthält oder daraus besteht, wobei das Material bevorzugt einen spezifischen elektrischen Widerstand von ≥ 10¹⁰ Ω·mm²/m, besonders bevorzugt ≥ 10¹¹ Ω·mm²/m, aufweisen.

Ferner kann die mindestens eine Lage, optional auch die mindestens eine weitere Lage, ein organisches Material enthalten oder daraus bestehen, bevorzugt einen polymeren Kunststoff enthalten oder daraus bestehen. Der polymere Kunststoff ist besonders bevorzugt ausgewählt aus der Gruppe bestehend aus Polyolefin, Fluorpolymer, Polyamid, Polyimid und Kombinationen hiervon, wobei der polymere Kunststoff insbesondere ausgewählt ist aus der Gruppe bestehend aus Polyethylen, Polypropylen, Polytetrafluorethylen, Polyamid, Para-Aramid, Polyimid und Kombinationen hiervon.

Darüber hinaus kann die mindestens eine Lage, optional auch die mindestens eine weitere Lage, ein anorganisches Material enthalten oder daraus bestehen, bevorzugt ein keramisches Material enthalten oder daraus bestehen, wobei das keramische Material insbesondere ausgewählt ist aus der Gruppe bestehend aus Oxid-Keramik, Carbid-Keramik, Nitrid-Keramik und Phosphat-Keramik. Bei der Oxid-Keramik kann es sich um Aluminiumoxid (Al₂O₃) handeln. Al₂O₃ hat den Vorteil, dass es kostengünstig im Vergleich zu Festelektrolytsalzen wie Lithiumphosphorsulfid ist. Ferner bildet Al₂O₃ eine inerte Schutzschicht und damit keine unerwünschten Nebenreaktionen. Zudem stellt Al₂O₃ (in Form von Partikeln) eine poröse Struktur bereit, was die Elektrolytverteilung verbessert und einen SEI-Precursor-Effekt bewirkt.

Darüber hinaus kann die mindestens eine Lage, optional auch die mindestens eine weitere Lage, ein ionenleitfähiges Material enthalten oder daraus bestehen.

Die mindestens eine Lage, optional auch die mindestens eine weitere Lage, kann eine Dicke, in einer Richtung senkrecht auf die Oberfläche der flächigen Elektrode, im Bereich von 1 µm bis 300 µm, bevorzugt im Bereich von 1 µm bis 100 µm, aufweisen.

Ferner kann die mindestens eine Lage, optional auch die mindestens eine weitere Lage, eine Porosität im Bereich von 30% bis 70%, bevorzugt im Bereich von 40% bis 60%, besonders bevorzugt im Bereich von 45% bis 50 % aufweisen.

Das Material, das zumindest in einem Teil der Poren der Separatormembran angeordnet ist, in dem Zwischenraum zwischen der Oberfläche der flächigen Elektrode und der ersten Oberfläche der Separatormembran angeordnet ist und in den Poren der Oberfläche der flächigen Elektrode angeordnet ist, kann eine Polymer enthalten oder daraus bestehen.

Das Polymer kann ein nicht-ionenleitendes Polymer und/oder ein ionenleitendes Polymer enthalten oder daraus bestehen. Beispielsweise kann das Polymer ein Fluorpolymer und/oder ein Polyethylenoxid enthalten oder daraus bestehen, wobei das Fluorpolymer bevorzugt ausgewählt ist aus der Gruppe bestehend aus PVDF-HFP, PVDF und Kombinationen hiervon. Der Vorteil von PVDF-HFP ist, dass es sich sehr gut in Aceton löst und ein Netzpolymer ausbildet, d.h. eine Stützmatrix, die eine verbesserte Elektrolytverteilung bewirkt und als Fixateur für ein SEI dient.

Das Material, das zumindest in einem Teil der Poren der Separatormembran angeordnet ist, in dem Zwischenraum zwischen der Oberfläche der flächige Elektrode und der ersten Oberfläche der Separatormembran angeordnet ist und in den Poren der Oberfläche der flächigen Elektrode angeordnet ist, kann anorganische Partikel enthalten oder daraus bestehen.

Die anorganischen Partikel können nicht-elektrisch-leitende anorganische Partikel, besonders bevorzugt nicht-elektrisch-leitende keramische Partikel, sein.

Ferner können die anorganischen Partikel ionenleitende anorganische Partikel sein, besonders bevorzugt ionenleitende anorganische Partikel, die ein sulfidisches Salz enthalten oder daraus bestehen, wobei das sulfidische Salz insbesondere ausgewählt ist aus der Gruppe bestehend aus Lithiumphosphorsulfid (Li₃PS₄), Lithium-Germanium-Phosphorsulfid (Li₁₀GeP₂S₁₂), Lithium-Silizium-Phosphorsulfid (Li₁₁Si₂PS₁₂), Li₆PS₅Cl, Li₆PS₅Br und Kombinationen hiervon. Der Vorteil von sulfidische Salzen ist, dass eine hohe, mit kommerziellen Flüssigelektrolyten konkurrierbare, ionische Leitfähigkeit erreicht wird.

Die Elektrode kann zumindest in einem Teil der Poren der Separatormembran, in dem Zwischenraum zwischen der Oberfläche der flächigen Elektrode und der ersten Oberfläche der Separatormembran und in den Poren der Oberfläche der flächigen Elektrode einen Flüssigelektrolyten aufweisen, wobei der Flüssigelektrolyt insbesondere die Oberfläche der flächigen Elektrode und die erste Oberfläche der Separatormembran kontaktiert.

Der Flüssigelektrolyt kann eine Flüssigkeit enthalten, die ausgewählt ist aus der Gruppe bestehend aus EC, PC, DMC, EMC, DEC, VEC, VC, FEC, TBAC (Acetyltributylcitrat), GTB (Glycerintributyrat), GTA (Glycerintriacetat), y-Buthyrolacton und Kombinatonen hiervon, wobei die Flüssigkeit bevorzugt ausgewählt ist aus der Gruppe bestehend aus PC, FEC, EC, VEC, TBAC, GTB, GTA und Kombinationen hiervon. Der Vorteil von PC, FEC, EC, VEC, TBAC, GTB, GTA liegt in ihrem hohen Siedepunkt und Temperaturbeständigkeit, was die Brandgefahr herabsetzt und die Betriebssicherheit erhöht.

Ferner kann der Flüssigelektrolyt ein Lithium-Leitsalz enthalten, wobei das Lithium-Leitsalz bevorzugt ausgewählt ist aus der Gruppe bestehend aus LiPF₆, LiClO₄, LiNO₃, C₆H₁₈LiNSi₂, F₂LiNO₄S₂, C₂F₆LiNO₄S₂, LiB[C₂O₄]₂, LiBF₄ und Kombinationen hiervon.

Abgesehen davon kann der Flüssigelektrolyt ein Natrium-Leitsalz enthalten, wobei das Natrium-Leitsalz bevorzugt ausgewählt ist aus der Gruppe bestehend aus NaPF₆, NaBF₄, NaTF, NaTFSI, NaClO₄ und Kombinationen hiervon.

Die erfindungsgemäße Elektrode kann über das erfindungsgemäße Verfahren hergestellt sein.

Erfindungsgemäß wird zudem eine galvanische Zelle bereitgestellt, enthaltend eine erfindungsgemäße Elektrode, eine Gegenelektrode und einen Elektrolyten.

Es wird die Verwendung der erfindungsgemäßen galvanischen Zelle zur Energieversorgung i) einer mobilen Vorrichtung, bevorzugt eines Mobiltelefons, eines Fahrzeugs, eines Flugzeugs und/oder eines Schiffs; und/oder ii) einer stationären Vorrichtung, bevorzugt eines Gebäudes, vorgeschlagen.

Anhang der nachfolgenden Figur und des nachfolgenden Beispiels soll der erfindungsgemäße Gegenstand näher erläutert werden, ohne diesen auf die hier gezeigten, spezifischen Ausführungsformen einschränken zu wollen.

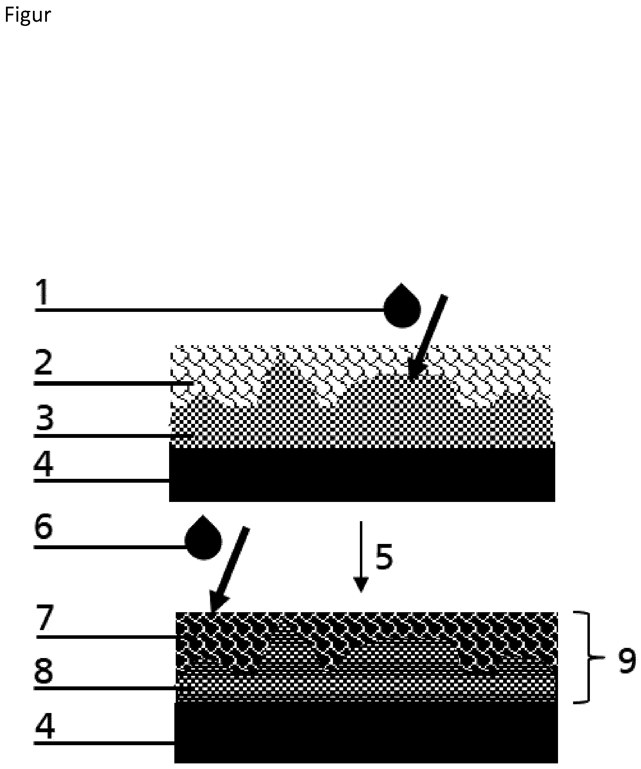

Die Figur zeigt schematisch eine erfindungsgemäße Elektrode, deren Herstellung und deren Behandlung mit einem Flüssigelektrolyten. Es wird eine flächige Elektrode 4 bereitgestellt und an ihrer Oberfläche eine Separatormembran 2 angeordnet. Es wird nun eine Flüssigkeit 1, die ein in einem organischen Lösungsmittel (z.B. Aceton) gelöstes Polymer (z.B. PVDF-HFP) enthält oder daraus besteht, auf die Separatormembran 2 aufgebracht, wodurch die Flüssigkeit in die Poren der Separatormembran 2, in den Zwischenraum zwischen Separatormembran 2 und flächiger Elektrode 4 und in Poren der Oberfläche der flächigen Elektrode 4 vordringt. Die Flüssigkeit wird verdampft, wodurch das Material in den Poren der Separatormembran 2, in dem Zwischenraum zwischen Separatormembran und flächiger Elektrode 4 und in den Poren der Oberfläche der flächigen Elektrode 4 zurückbleibt und eine angereicherte Materialschicht 3 entsteht. Anschließend wird in einem weiteren Schritt 5 ein Flüssigelektroyt 6 auf die Separatormembran 2 aufgebracht, wodurch ein Verbund 9 aus einer mit Flüssigelektrolyt getränkten Separatormembran 7 und einer mit Flüssigelektrolyt 6 getränkten Materialschicht 8 entsteht. Das Material, das sich in den Poren der Separatormembran 7, in der Materialschicht 8 und in den Poren der Oberfläche der flächigen Elektrode 4 befindet, kann durch den Flüssigelektrolyt gequollen sein.

### Beispiel - Herstellung einer Elektrode für eine galvanische Zelle

Auf eine Ableiterfolie wird eine Polyolefinmembran aufgebracht. Es wird eine Flüssigkeit hergestellt, die ein organisches Lösungsmittel und ein darin gelöstes Polymer enthält. Diese Flüssigkeit wird auf die Polyolefinmembran pipettiert, wodurch die Flüssigkeit zur Grenzfläche zwischen dem Ableiter und der Polyolefinmembran (Zwischenraum) vordringt. Das organische Lösungsmittel wird anschließend verdampft, wodurch das Polymer, das sich nun in den Poren der Polyolefinmembran, im Zwischenraum zwischen der Polyolefinmembran und der Ableiterfolie und in den Poren an der Oberfläche der Ableiterfolie befindet, hart wird.

Nun kann ein Flüssigelektrolyt auf die Polyolefinmembran aufgebracht werden, wodurch der Flüssigelektrolyt in die Bereiche vordringt, in denen sich auch das Polymer befindet. Das Polymer kann durch den Flüssigelektrolyt gequollen (bzw. gelifiziert) werden. Dieser Schritt kann auch erst bei der Verwendung der Elektrode in einer galvanischen Zelle erfolgen.

### Bezugszeichenliste

- 1:: Flüssigkeit mit Material, bestehend beispielsweise aus einem organischen Lösungsmittel (z.B. Aceton) mit einem gelösten Polymer (z.B. PVDF-HFP);
- 2:: Separatormembran (ohne Flüssigelektrolyt);
- 3:: Angereicherte Materialschicht, die aus der Materialanreicherung (z.B. Polymer) in den Poren der Separatormembran, dem Zwischenraum und den Poren der flächigen Elektrode nach dem Verdampfen des organischen Lösemittels (z.B. Aceton) entsteht
- 4:: flächige Elektrode (z.B. Aluminiumfolie);
- 5:: Schritt des Aufbringens von Flüssigelektrolyt;
- 6:: Flüssigelektrolyt;
- 7:: mit Flüssigelektrolyt getränkte Separatormembran;
- 8:: mit Flüssigelektrolyt getränkte angereicherte Materialschicht; und
- 9:: Verbund aus mit Flüssigelektrolyt getränkter Separatormembran und mit Flüssigelektrolyt getränkter Materialschicht.

## Patentansprüche

1. Verfahren zur Herstellung einer Elektrode für eine galvanische Zelle, umfassend
a) Bereitstellen einer flächigen Elektrode, wobei die flächige Elektrode eine Oberfläche aufweist;
b) Aufbringen einer ersten Oberfläche einer Separatormembran auf die Oberfläche der flächigen Elektrode, sodass sich zwischen der Oberfläche der flächigen Elektrode und der ersten Oberfläche der Separatormembran ein Zwischenraum ausbildet;
c) Aufbringen einer Flüssigkeit auf eine zweite Oberfläche der Separatormembran, die der ersten Oberfläche gegenüberliegt, wobei die Flüssigkeit ein Lösungsmittel und ein Material enthält, das ausgewählt ist aus der Gruppe bestehend aus Polymer, anorganische Partikel, organische Partikel und Kombinationen hiervon, wobei die Flüssigkeit mit ihrem Lösungsmittel und ihrem Material über Kapillarkräfte zumindest in die Poren der Separatormembran, in den Zwischenraum zwischen der Oberfläche der flächigen Elektrode und der ersten Oberfläche der Separatormembran und in Poren der Oberfläche der flächigen Elektrode vordringt; und
d) Verdampfen des Lösungsmittels der Flüssigkeit, wobei eine Elektrode entsteht, die das Material der Flüssigkeit in dem Zwischenraum zwischen der Oberfläche der Elektrode und der ersten Oberfläche der Separatormembran enthält und in zumindest in einem Teil der Poren enthält, wobei das Material die Oberfläche der Elektrode und die erste Oberfläche der Separatormembran flächig kontaktiert.

2. Verfahren gemäß dem vorhergehenden Anspruch, **dadurch gekennzeichnet, dass** die flächige Elektrode
i) ein Alkalimetall, optional auf ein Metall ausgewählt aus der Gruppe bestehend aus Edelstahl, Nickel, Kupfer, Indium, Aluminium und Kombinationen hiervon beschichtet, enthält oder daraus besteht, wobei das Alkalimetall bevorzugt ausgewählt ist aus der Gruppe bestehend aus Lithium, Natrium und Kombinationen hiervon; und/oder
ii) Kohlenstoff enthält oder daraus besteht, bevorzugt einen Kohlenstoff, der ausgewählt ist aus der Gruppe bestehend aus Graphit, Graphen und Kombinationen hiervon; und/oder
iii) Silizium, eine Siliziumlegierung und/oder ein Siliziumkomposit enthält oder daraus besteht; und/oder
iv) ein Metall ausgewählt aus der Gruppe bestehend aus Edelstahl, Nickel, Kupfer, Indium, Aluminium, bevorzugt Aluminium, enthält oder daraus besteht, wobei das Aluminium optional legiert ist, bevorzugt mit mindestens einem Element ausgewählt aus der II. Hauptgruppe des Periodensystems, der III. Hauptgruppe des Periodensystems, der IV. Hauptgruppe des Periodensystems, einer Nebengruppe des Periodensystems und Kombinationen hiervon, wobei das mindestens eine Element bevorzugt ausgewählt ist aus der Gruppe bestehend aus Magnesium, Indium, Zink, Zinn, Silizium, Mangan und Kombinationen hiervon; und/oder
v) ein Kathodenmaterial enthält oder daraus besteht, das bevorzugt ausgewählt ist aus der Gruppe bestehend aus Nickel-Mangan-Kobaltoxid, Lithiumeisenphosphat, Lithium-Manganoxid, Lithium-Nickel-Manganoxid, Lithium-Nickeloxid, Lithium-Kobaltoxid, Lithium-Aluminium-Nickeloxid, Lithiummanganphosphat, Lithiumeisenmanganphosphat und Kombinationen hiervon; und/oder
vi) eine Dicke, in einer Richtung senkrecht auf die Oberfläche der flächigen Elektrode, im Bereich von 5 bis 100 µm, bevorzugt 10 bis 50 µm, besonders bevorzugt 20 bis 40 µm, aufweist; und/oder
vii) auf ihrer Oberfläche eine Oberflächenstrukturierung aufweist, wobei die Oberflächenstrukturierung bevorzugt eine Strukturtiefe im Bereich von 1 nm bis 100 µm aufweist, wobei die Oberflächenstrukturierung besonders bevorzugt ausgewählt ist aus der Gruppe bestehend aus geprägte Oberflächenstrukturierung, gebürstete Oberflächenstrukturierung, gemusterte Oberflächenstrukturierung, geriffelte Oberflächenstrukturierung und Kombinationen hiervon.

3. Verfahren gemäß einem der vorhergehenden Ansprüche, **dadurch gekennzeichnet, dass** die Separatormembran aus einer mindestens einer Lage, optional auch mindestens einer weiteren Lage, besteht, wobei die mindestens eine Lage, optional auch die mindestens eine weitere Lage
i) ein elektrisch isolierendes Material enthält oder daraus besteht, wobei das Material bevorzugt einen spezifischen elektrischen Widerstand von ≥ 10¹⁰ Ω·mm²/m, besonders bevorzugt ≥ 10¹¹ Ω·mm²/m, aufweist; und/oder
ii) ein organisches Material enthält oder daraus besteht, bevorzugt einen polymeren Kunststoff enthält oder daraus besteht, wobei der polymere Kunststoff besonders bevorzugt ausgewählt ist aus der Gruppe bestehend aus Polyolefin, Fluorpolymer, Polyamid, Polyimid und Kombinationen hiervon, wobei der polymere Kunststoff insbesondere ausgewählt ist aus der Gruppe bestehend aus Polyethylen, Polypropylen, Polytetrafluorethylen, Polyamid, Para-Aramid, Polyimid und Kombinationen hiervon; und/oder
iii) ein anorganisches Material enthält oder daraus besteht, bevorzugt ein keramisches Material enthält oder daraus besteht, wobei das keramische Material insbesondere ausgewählt ist aus der Gruppe bestehend aus Oxid-Keramik, Carbid-Keramik, Nitrid-Keramik und Phosphat-Keramik; und/oder
iv) eine Dicke, in einer Richtung senkrecht auf die Oberfläche der flächigen Elektrode, im Bereich von 1 µm bis 300 µm, bevorzugt im Bereich von 1 µm bis 100 µm, aufweist; und/oder
v) eine Porosität im Bereich von 30% bis 70%, bevorzugt im Bereich von 40% bis 60%, besonders bevorzugt im Bereich von 45% bis 50 % aufweist.

4. Verfahren gemäß einem der vorhergehenden Ansprüche, **dadurch gekennzeichnet, dass** die Flüssigkeit ein Lösungsmittel enthält, das bei Atmosphärendruck einen Siedepunkt von ≤ 156 °C, bevorzugt ≤ 80 °C, besonders bevorzugt ≤ 56 °C, aufweist und/oder bei 20 °C einen Dampfdruck von ≥ 3 hPa, bevorzugt ≥ 58 hPa, besonders bevorzugt ≥ 246 hPa, aufweist, wobei das optional ausgewählt ist aus der Gruppe bestehend aus Aceton, DEC, DMAC, 3-Hexanon, THF, Butanon, 3-Pentanone, Toluol, p-Xylene, Ethanol und Mischungen hiervon, wobei das Lösungsmittel insbesondere Aceton ist.

5. Verfahren gemäß einem der vorhergehenden Ansprüche, **dadurch gekennzeichnet, dass** das Material der Flüssigkeit ein Polymer enthält oder daraus besteht, das in dem Lösungsmittel gelöst ist, wobei das Polymer bevorzugt
i) ein nicht-ionenleitendes Polymer und/oder ein ionenleitendes Polymer enthält oder daraus besteht; und/oder
ii) ein Fluorpolymer und/oder ein Polyethylenoxid enthält oder daraus besteht, wobei das Fluorpolymer bevorzugt ausgewählt ist aus der Gruppe bestehend aus PVDF-HFP, PVDF und Kombinationen hiervon; und/oder
iii) in einer Konzentration von 60 Gew.-% bis 80 Gew.-%, bevorzugt 65 Gew.-% bis 75 Gew.-%, insbesondere 70 Gew.-%, in Bezug auf das Gesamtgewicht der Flüssigkeit, in der Flüssigkeit vorliegt.

6. Verfahren gemäß einem der vorhergehenden Ansprüche, **dadurch gekennzeichnet, dass** das Material der Flüssigkeit anorganische Partikel enthält oder daraus besteht, die in dem Lösungsmittel dispergiert sind, wobei die anorganischen Partikel bevorzugt
i) nicht-elektrisch-leitende anorganische Partikel, besonders bevorzugt nicht-elektrisch-leitende keramische Partikel, sind; und/oder
ii) ionenleitende anorganische Partikel, besonders bevorzugt ionenleitende anorganische Partikel, die ein sulfidisches Salz enthalten oder daraus bestehen, sind, wobei das sulfidische Salz insbesondere ausgewählt ist aus der Gruppe bestehend aus Lithiumphosphorsulfid, Lithium-Germanium-Phosphorsulfid, Lithium-Silizium-Phosphorsulfid, Li₆PS₅Cl, Li₆PS₅Br und Kombinationen hiervon.

7. Verfahren gemäß einem der vorhergehenden Ansprüche, **dadurch gekennzeichnet, dass** das Verfahren nach Schritt d) ferner umfasst:
Aufbringen eines Flüssigelektrolyten für eine galvanische Zelle auf die zweite Oberfläche der Separatormembran, wobei der Flüssigelektrolyt über Kapillarkräfte zumindest in einem Teil der Poren der Separatormembran, in den Zwischenraum zwischen der Oberfläche der flächige Elektrode und der ersten Oberfläche der Separatormembran und in die Poren der Oberfläche der flächigen Elektrode vordringt, wobei der Flüssigelektrolyt insbesondere die Oberfläche der flächige Elektrode und die erste Oberfläche der Separatormembran kontaktiert.

8. Elektrode für eine galvanische Zelle, enthaltend oder bestehend aus
a) eine flächige Elektrode, wobei die flächige Elektrode eine Oberfläche aufweist;
b) eine Separatormembran, die eine erste Oberfläche aufweist, eine zweite Oberfläche, die der ersten Oberfläche gegenüberliegt, aufweist, und Poren aufweist, wobei die erste Oberfläche der Separatormembran auf der Oberfläche der flächigen Elektrode aufgebracht ist, und zwischen der Oberfläche der flächige Elektrode und der ersten Oberfläche der Separatormembran ein Zwischenraum besteht;
c) ein Material, das ausgewählt ist aus der Gruppe bestehend aus Polymer, anorganische Partikel, organische Partikel und Kombinationen hiervon, wobei das Material zumindest in einem Teil der Poren der Separatormembran angeordnet ist, in dem Zwischenraum zwischen der Oberfläche der flächige Elektrode und der ersten Oberfläche der Separatormembran angeordnet ist und in Poren der Oberfläche der flächigen Elektrode angeordnet ist, und wobei das Material die erste Oberfläche der Separatormembran und die Oberfläche der flächige Elektrode flächig kontaktiert.

9. Elektrode gemäß Anspruch 8, **dadurch gekennzeichnet, dass** die flächige Elektrode
i) ein Alkalimetall, optional auf ein Metall ausgewählt aus der Gruppe bestehend aus Edelstahl, Nickel, Kupfer, Indium, Aluminium und Kombinationen hiervon beschichtet, enthält oder daraus besteht, wobei das Alkalimetall bevorzugt ausgewählt ist aus der Gruppe bestehend aus Lithium, Natrium und Kombinationen hiervon; und/oder
ii) Kohlenstoff enthält oder daraus besteht, bevorzugt einen Kohlenstoff, der ausgewählt ist aus der Gruppe bestehend aus Graphit, Graphen und Kombinationen hiervon; und/oder
iii) Silizium, eine Siliziumlegierung und/oder ein Siliziumkomposit enthält oder daraus besteht; und/oder
iv) ein Metall ausgewählt aus der Gruppe bestehend aus Edelstahl, Nickel, Kupfer, Indium, Aluminium, bevorzugt Aluminium enthält oder daraus besteht, wobei das Aluminium optional legiert ist, bevorzugt mit mindestens einem Element ausgewählt aus der II. Hauptgruppe des Periodensystems, der III. Hauptgruppe des Periodensystems, der IV. Hauptgruppe des Periodensystems, einer Nebengruppe des Periodensystems und Kombinationen hiervon, wobei das mindestens eine Element bevorzugt ausgewählt ist aus der Gruppe bestehend aus Magnesium, Indium, Zink, Zinn, Silizium, Mangan und Kombinationen hiervon; und/oder
v) ein Kathodenmaterial enthält oder daraus besteht, das bevorzugt ausgewählt ist aus der Gruppe bestehend aus Nickel-Mangan-Kobaltoxid, Lithiumeisenphosphat, Lithium-Manganoxid, Lithium-Nickel-Manganoxid, Lithium-Nickeloxid, Lithium-Kobaltoxid, Lithium-Aluminium-Nickeloxid, Lithiummanganphosphat, Lithiumeisenmanganphosphat und Kombinationen hiervon; und/oder
vi) eine Dicke, in einer Richtung senkrecht auf die Oberfläche der flächigen Elektrode, im Bereich von 5 bis 100 µm, bevorzugt 10 bis 50 µm, besonders bevorzugt 20 bis 40 µm, aufweist; und/oder
vii) auf der Oberfläche der flächige Elektrode eine Oberflächenstrukturierung aufweist, wobei die Oberflächenstrukturierung bevorzugt eine Strukturtiefe im Bereich von 1 nm bis 100 µm aufweist, wobei die Oberflächenstrukturierung besonders bevorzugt ausgewählt ist aus der Gruppe bestehend aus geprägte Oberflächenstrukturierung, gebürstete Oberflächenstrukturierung, geriffelte Oberflächenstrukturierung, gemusterte Oberflächenstrukturierung, und Kombinationen hiervon.

10. Elektrode gemäß einem der Ansprüche 8 oder 9, **dadurch gekennzeichnet, dass** die Separatormembran aus einer mindestens einer Lage, optional auch mindestens einer weiteren Lage, besteht, wobei die mindestens eine Lage, optional auch die mindestens eine weitere Lage,
i) ein elektrisch isolierendes Material enthält oder daraus besteht, wobei das Material bevorzugt einen spezifischen elektrischen Widerstand von ≥ 10¹⁰ Ω·mm²/m, besonders bevorzugt ≥ 10¹¹ Ω·mm²/m, aufweist; und/oder
ii) ein organisches Material enthält oder daraus besteht, bevorzugt einen polymeren Kunststoff enthält oder daraus besteht, wobei der polymere Kunststoff besonders bevorzugt ausgewählt ist aus der Gruppe bestehend aus Polyolefin, Fluorpolymer, Polyamid, Polyimid und Kombinationen hiervon, wobei der polymere Kunststoff insbesondere ausgewählt ist aus der Gruppe bestehend aus Polyethylen, Polypropylen, Polytetrafluorethylen, Polyamid, Para-Aramid, Polyimid und Kombinationen hiervon; und/oder
iii) ein anorganisches Material enthält oder daraus besteht, bevorzugt ein keramisches Material enthält oder daraus besteht, wobei das keramische Material insbesondere ausgewählt ist aus der Gruppe bestehend aus Oxid-Keramik, Carbid-Keramik, Nitrid-Keramik und Phosphat-Keramik; und/oder
iv) eine Dicke, in einer Richtung senkrecht auf die Oberfläche der flächigen Elektrode, im Bereich von 1 µm bis 300 µm, bevorzugt im Bereich von 1 µm bis 100 µm, aufweist; und/oder
v) eine Porosität im Bereich von 30% bis 70%, bevorzugt im Bereich von 40% bis 60%, besonders bevorzugt im Bereich von 45% bis 50 % aufweist.

11. Elektrode gemäß einem der Ansprüche 8 bis 10, **dadurch gekennzeichnet, dass** das Material, das zumindest in einem Teil der Poren der Separatormembran angeordnet ist, in dem Zwischenraum zwischen der Oberfläche der flächigen Elektrode und der ersten Oberfläche der Separatormembran angeordnet ist und in den Poren der Oberfläche der flächigen Elektrode angeordnet ist, eine Polymer enthält oder daraus besteht, wobei das Polymer bevorzugt
i) ein nicht-ionenleitendes Polymer und/oder ein ionenleitendes Polymer enthält oder daraus besteht; und/oder
ii) ein Fluorpolymer und/oder ein Polyethylenoxid enthält oder daraus besteht, wobei das Fluorpolymer bevorzugt ausgewählt ist aus der Gruppe bestehend aus PVDF-HFP, PVDF und Kombinationen hiervon.

12. Elektrode gemäß einem der Ansprüche 8 bis 11, **dadurch gekennzeichnet, dass** das Material, das zumindest in einem Teil der Poren der Separatormembran angeordnet ist, in dem Zwischenraum zwischen der Oberfläche der flächigen Elektrode und der ersten Oberfläche der Separatormembran angeordnet ist und in den Poren der Oberfläche der flächigen Elektrode angeordnet ist, anorganische Partikel enthält oder daraus besteht, wobei die anorganischen Partikel bevorzugt
i) nicht-elektrisch-leitende anorganische Partikel, besonders bevorzugt nicht-elektrisch-leitende keramische Partikel, sind; und/oder
ii) ionenleitende anorganische Partikel, besonders bevorzugt ionenleitende anorganische Partikel, die ein sulfidisches Salz enthalten oder daraus bestehen, sind, wobei das sulfidische Salz insbesondere ausgewählt ist aus der Gruppe bestehend aus Lithiumphosphorsulfid, Lithium-Germanium-Phosphorsulfid, Lithium-Silizium-Phosphorsulfid, Li₆PS₅Cl, Li₆PS₅Br und Kombinationen hiervon.

13. Elektrode gemäß einem der Ansprüche 8 bis 12, **dadurch gekennzeichnet, dass** zumindest in einem Teil der Poren der Separatormembran, in dem Zwischenraum zwischen der Oberfläche der flächigen Elektrode und der ersten Oberfläche der Separatormembran und in den Poren der Oberfläche der flächigen Elektrode ein Flüssigelektrolyt angeordnet ist, wobei der Flüssigelektrolyt insbesondere die Oberfläche der flächige Elektrode und die erste Oberfläche der Separatormembran kontaktiert.

14. Galvanische Zelle, enthaltend eine Elektrode gemäß einem der Ansprüche 8 bis 13, eine Gegenelektrode und einen Elektrolyten.

15. Verwendung der galvanischen Zelle gemäß Anspruch 14 zur Energieversorgung
i) einer mobilen Vorrichtung, bevorzugt eines Mobiltelefons, eines Fahrzeugs, eines Flugzeugs und/oder eines Schiffs; und/oder
ii) einer stationären Vorrichtung, bevorzugt eines Gebäudes.

## Claims

1. A method for producing an electrode for a galvanic cell, comprising the steps of
a) providing a areal electrode, wherein the areal electrode has a surface;
b) applying a first surface of a separator membrane to the surface of the areal electrode so that an intermediate space is formed between the surface of the areal electrode and the first surface of the separator membrane;
c) applying a liquid to a second surface of the separator membrane opposite the first surface, wherein the liquid comprises a solvent and a material selected from the group consisting of polymer, inorganic particles, organic particles and combinations thereof, wherein the liquid comprising its solvent and its material penetrates, by way of capillary forces, at least into the pores of the separator membrane, into the intermediate space between the surface of the areal electrode and the first surface of the separator membrane, and into pores of the surface of the areal electrode; and
d) evaporating the solvent of the liquid, wherein an electrode is created, which comprises the material of the liquid in the intermediate space between the surface of the electrode and the first surface of the separator membrane and in at least a proportion of the pores, wherein the material contacts the surface of the electrode and the first surface of the separator membrane extensively.

2. The method according to the preceding claim, **characterized in that** the areal electrode
i) comprises or consists of an alkali metal, optionally coated on a metal selected from the group consisting of stainless steel, nickel, copper, indium, aluminium and combinations thereof, wherein the alkali metal is preferably selected from the group consisting of lithium, sodium and combinations thereof; and/or
ii) comprises or consists of carbon, preferably a carbon selected from the group consisting of graphite, graphene and combinations thereof; and/or
iii) comprises or consists of silicon, a silicon alloy and/or a silicon composite; and/or
iv) comprises or consists of a metal selected from the group consisting of stainless steel, nickel, copper, indium, aluminium, preferably aluminium, wherein the aluminium is optionally alloyed, preferably with at least one element selected from the II. main group of the periodic table, the III. main group of the periodic table, the IV. main group of the periodic table, a subgroup of the periodic table and combinations thereof, wherein the at least one element is preferably selected from the group consisting of magnesium, indium, zinc, tin, silicon, manganese and combinations thereof; and/or
v) comprises or consists of a cathode material, which is preferably selected from the group consisting of nickel manganese cobalt oxide, lithium iron phosphate, lithium manganese oxide, lithium nickel manganese oxide, lithium nickel oxide, lithium cobalt oxide, lithium aluminum nickel oxide, lithium manganese phosphate, lithium iron manganese phosphate, and combinations thereof; and/or
vi) has a thickness, in a direction perpendicular to the surface of the areal electrode, in the range from 5 to 100 µm, preferably 10 to 50 µm, particularly preferably 20 to 40 µm; and/or
vii) has a surface structuring on its surface, wherein the surface structuring preferably has a structure depth in the range from 1 nm to 100 µm, wherein the surface structuring is particularly preferably selected from the group consisting of embossed surface structuring, brushed surface structuring, patterned surface structuring, corrugated surface structuring and combinations thereof.

3. The method according to any one of the preceding claims, **characterized in that** the separator membrane consists of at least one layer, optionally also at least one further layer, wherein the at least one layer, optionally also the at least one further layer
i) comprises or consists of an electrically insulating material, wherein the material preferably has a specific electrical resistance of ≥ 10¹⁰ Ω·mm²/m, particularly preferably ≥ 10¹¹ Ω·mm²/m; and/or
ii) comprises or consists of an organic material, preferably comprises or consists of a polymeric plastic, wherein the polymeric plastic is particularly preferably selected from the group consisting of polyolefin, fluoropolymer, polyamide, polyimide and combinations thereof, wherein the polymeric plastic is in particular selected from the group consisting of polyethylene, polypropylene, polytetrafluoroethylene, polyamide, para-aramide, polyimide and combinations thereof; and/or
iii) comprises or consists of an inorganic material, preferably comprises or consists of a ceramic material, wherein the ceramic material is selected in particular from the group consisting of oxide ceramics, carbide ceramics, nitride ceramics and phosphate ceramics; and/or
iv) has a thickness, in a direction perpendicular to the surface of the areal electrode, in the range from 1 µm to 300 µm, preferably in the range from 1 µm to 100 µm; and/or
v) has a porosity in the range of from 30% to 70%, preferably in the range from 40% to 60%, particularly preferably in the range from 45% to 50%.

4. The method according to any one of the preceding claims,
**characterized in that** the liquid comprises a solvent which has a boiling point at atmospheric pressure of ≤ 156°C, preferably ≤ 80°C, particularly preferably ≤ 56°C, and/or has a vapour pressure at 20°C of ≥ 3 hPa, preferably ≥ 58 hPa, particularly preferably ≥ 246 hPa, wherein the solvent is optionally selected from the group consisting of acetone, DEC, DMAC, 3-hexanone, THF, butanone, 3-pentanone, toluene, p-xylene, ethanol and mixtures thereof, wherein the solvent is particularly acetone.

5. The method according to any one of the preceding claims, **characterized in that** the material of the liquid comprises or consists of a polymer dissolved in the solvent, wherein the polymer preferably
i) comprises or consists of a non-ion-conducting polymer and/or an ion-conducting polymer; and/or
ii) comprises or consists of a fluoropolymer and/or a polyethylene oxide, wherein the fluoropolymer is preferably selected from the group consisting of PVDF-HFP, PVDF and combinations thereof; and/or
iii) is present in the liquid in a concentration from 60 wt.% to 80 wt.%, preferably 65 wt.% to 75 wt., in particular 70 wt.%, in relation to the total weight of the liquid.

6. The method according to any one of the preceding claims, **characterized in that** the material of the liquid comprises or consists of inorganic particles which are dispersed in the solvent, wherein the inorganic particles preferably
i) are non-electrically conductive inorganic particles, particularly preferably non-electrically conductive ceramic particles; and/or
ii) are ion-conducting inorganic particles, particularly preferably ion-conducting inorganic particles comprising or consisting of a sulfidic salt, wherein the sulfidic salt is particularly selected from the group consisting of lithium phosphorus sulfide, lithium germanium phosphorus sulfide, lithium silicon phosphorus sulfide, Li₆PS₅Cl, Li₆PS₅Br and combinations thereof.

7. The method according to any one of the preceding claims, **characterized in that** the method further comprises after step d):
applying a liquid electrolyte for a galvanic cell to the second surface of the separator membrane, wherein the liquid electrolyte penetrates, by way of capillary forces, at least in a proportion of the pores of the separator membrane, into the intermediate space between the surface of the areal electrode and the first surface of the separator membrane, and into the pores of the surface of the areal electrode, wherein the liquid electrolyte contacts in particular the surface of the areal electrode and the first surface of the separator membrane.

8. An electrode for a galvanic cell, comprising or consisting of
a) a areal electrode, wherein the areal electrode has a surface;
b) a separator membrane having a first surface, a second surface opposite the first surface, and pores, wherein the first surface of the separator membrane is applied to the surface of the areal electrode, and there is an intermediate space between the surface of the areal electrode and the first surface of the separator membrane;
c) a material selected from the group consisting of polymer, inorganic particles, organic particles, and combinations thereof, wherein the material is arranged in at least a proportion of the pores of the separator membrane, is arranged in the intermediate space between the surface of the areal electrode and the first surface of the separator membrane, and is arranged in pores of the surface of the areal electrode, and wherein the material contacts the first surface of the separator membrane and the surface of the areal electrode extensively.

9. The electrode according to claim 8, **characterized in that** the areal electrode
i) comprises or consists of an alkali metal, optionally coated on a metal selected from the group consisting of stainless steel, nickel, copper, indium, aluminium and combinations thereof, wherein the alkali metal is preferably selected from the group consisting of lithium, sodium and combinations thereof; and/or
ii) comprises or consists of carbon, preferably a carbon selected from the group consisting of graphite, graphene and combinations thereof; and/or
iii) comprises or consists of silicon, a silicon alloy and/or a silicon composite; and/or
iv) comprises or consists of a metal selected from the group consisting of stainless steel, nickel, copper, indium, aluminium, preferably aluminium, wherein the aluminium is optionally alloyed, preferably with at least one element selected from the II. main group of the periodic table, the III. main group of the periodic table, the IV. main group of the periodic table, a subgroup of the periodic table and combinations thereof, wherein the at least one element is preferably selected from the group consisting of magnesium, indium, zinc, tin, silicon, manganese and combinations thereof; and/or
v) comprises or consists of a cathode material, which is preferably selected from the group consisting of nickel manganese cobalt oxide, lithium iron phosphate, lithium manganese oxide, lithium nickel manganese oxide, lithium nickel oxide, lithium cobalt oxide, lithium aluminum nickel oxide, lithium manganese phosphate, lithium iron manganese phosphate, and combinations thereof; and/or
vi) has a thickness, in a direction perpendicular to the surface of the areal electrode, in the range from 5 to 100 µm, preferably 10 to 50 µm, particularly preferably 20 to 40 µm; and/or
vii) has a surface structuring on the surface of the areal electrode, wherein the surface structuring preferably has a structure depth in the range from 1 nm to 100 µm, wherein the surface structuring is particularly preferably selected from the group consisting of embossed surface structuring, brushed surface structuring, corrugated surface structuring, patterned surface structuring and combinations thereof.

10. The electrode according to any one of claims 8 or 9, **characterized in that** the separator membrane consists of at least one layer, optionally also at least one further layer, wherein the at least one layer, optionally also the at least one further layer,
i) comprises or consists of an electrically insulating material, wherein the material preferably has a specific electrical resistance of ≥ 10¹⁰ Ω·mm²/m, particularly preferably ≥ 10¹¹ Ω·mm²/m; and/or
ii) comprises or consists of an organic material, preferably comprises or consists of a polymeric plastic, wherein the polymeric plastic is particularly preferably selected from the group consisting of polyolefin, fluoropolymer, polyamide, polyimide and combinations thereof, wherein the polymeric plastic is in particular selected from the group consisting of polyethylene, polypropylene, polytetrafluoroethylene, polyamide, para-aramide, polyimide and combinations thereof; and/or
iii) comprises or consists of an inorganic material, preferably comprises or consists of a ceramic material, wherein the ceramic material is selected in particular from the group consisting of oxide ceramics, carbide ceramics, nitride ceramics and phosphate ceramics; and/or
iv) has a thickness, in a direction perpendicular to the surface of the areal electrode, in the range from 1 µm to 300 µm, preferably in the range from 1 µm to 100 µm; and/or
v) has a porosity in the range of from 30% to 70%, preferably in the range from 40% to 60%, particularly preferably in the range from 45% to 50%.

11. The electrode according to any one of claims 8 to 10, **characterized in that** the material, which is arranged in at least a proportion of the pores of the separator membrane, is arranged in the intermediate space between the surface of the areal electrode and the first surface of the separator membrane and is arranged in the pores of the surface of the areal electrode, comprises or consists of a polymer, wherein the polymer preferably
i) comprises or consists of a non-ion-conducting polymer and/or an ion-conducting polymer; and/or
ii) comprises or consists of a fluoropolymer and/or a polyethylene oxide, wherein the fluoropolymer is preferably selected from the group consisting of PVDF-HFP, PVDF and combinations thereof.

12. The electrode according to any one of claims 8 to 11, **characterized in that** the material, which is arranged in at least a proportion of the pores of the separator membrane, is arranged in the intermediate space between the surface of the areal electrode and the first surface of the separator membrane and is arranged in the pores of the surface of the areal electrode, comprises or consists of inorganic particles, wherein the inorganic particles preferably
i) are non-electrically conductive inorganic particles, particularly preferably non-electrically conductive ceramic particles; and/or
ii) are ion-conducting inorganic particles, particularly preferably ion-conducting inorganic particles comprising or consisting of a sulfidic salt, wherein the sulfidic salt is particularly selected from the group consisting of lithium phosphorus sulfide, lithium germanium phosphorus sulfide, lithium silicon phosphorus sulfide, Li₆PS₅Cl, Li₆PS₅Br and combinations thereof.

13. The electrode according to any one of claims 8 to 12, **characterized in that** a liquid electrolyte is arranged at least in a proportion of the pores of the separator membrane, in the intermediate space between the surface of the areal electrode and the first surface of the separator membrane and in the pores of the surface of the areal electrode, wherein the liquid electrolyte contacts in particular the surface of the areal electrode and the first surface of the separator membrane.

14. A galvanic cell comprising an electrode according to any one of claims 8 to 13, a counter electrode and an electrolyte.

15. Use of the galvanic cell according to claim 14 for power supply
i) of a mobile device, preferably a mobile phone, a vehicle, an aircraft and/or a ship; and/or
ii) of a stationary device, preferably a building.

## Revendications

1. Procédé de fabrication d'une électrode pour une cellule galvanique, comprenant les étapes consistant à :
a) fournir une électrode plane, dans lequel l'électrode plane présente une surface ;
b) appliquer une première surface d'une membrane de séparateur sur la surface de l'électrode plane, de sorte qu'un espace se forme entre la surface de l'électrode plane et la première surface de la membrane de séparateur;
c) appliquer un liquide sur une seconde surface de la membrane de séparateur opposée à la première surface, dans lequel le liquide contient un solvant et un matériau choisi dans le groupe constitué par un polymère, des particules inorganiques, des particules organiques et des combinaisons de ceux-ci, dans lequel le liquide avec son solvant et son matériau pénètre par l'intermédiaire de forces capillaires au moins dans les pores de la membrane de séparateur, dans l'espace entre la surface de l'électrode plane et la première surface de la membrane de séparateur et dans des pores de la surface de l'électrode plane ; et
d) évaporer le solvant du liquide, ce qui crée une électrode contenant le matériau du liquide dans l'espace entre la surface de l'électrode et la première surface de la membrane de séparateur et au moins dans une partie des pores, dans lequel le matériau est en contact plan avec la surface de l'électrode et la première surface de la membrane de séparateur.

2. Procédé selon la revendication précédente, **caractérisé en ce que** l'électrode plane
i) contient ou est constituée d'un métal alcalin, éventuellement enduit sur un métal choisi dans le groupe constitué de l'acier inoxydable, du nickel, du cuivre, de l'indium, de l'aluminium et de combinaisons de ceux-ci, dans lequel le métal alcalin est de manière préférée choisi dans le groupe constitué du lithium, du sodium et de combinaisons de ceux-ci ; et/ou
ii) contient ou est constituée de carbone, de manière préférée du carbone choisi dans le groupe constitué du graphite, du graphène et de combinaisons de ceux-ci ; et/ou
iii) contient ou est constituée de silicium, d'un alliage de silicium et/ou d'un composite à base de silicium ; et/ou
iv) contient ou est constituée d'un métal choisi dans le groupe constitué de l'acier inoxydable, du nickel, du cuivre, de l'indium, de l'aluminium, de manière préférée de l'aluminium, dans lequel l'aluminium est éventuellement allié, de manière préférée avec au moins un élément choisi dans le II^{e} groupe principal du tableau périodique, le III^{e} groupe principal du tableau périodique, le IV^{e} groupe principal du tableau périodique, un sous-groupe du tableau périodique et des combinaisons de ceux-ci, dans lequel au moins un élément est choisi de manière préférée dans le groupe constitué du magnésium, de l'indium, du zinc, de l'étain, du silicium, du manganèse et de combinaisons de ceux-ci ; et/ou
v) contient ou est constituée d'un matériau de cathode qui est de manière préférée choisi dans le groupe constitué de l'oxyde de nickel-manganèse-cobalt, du lithium-fer-phosphate, de l'oxyde de manganèse-lithium, de l'oxyde de nickel-manganèse-lithium, de l'oxyde de nickel-lithium, de l'oxyde de lithium-cobalt, de l'oxyde de lithium-nickel-aluminium, du phosphate de lithium-manganèse, et de combinaisons de ceux-ci ; et/ou
vi) présente dans une direction perpendiculaire à la surface de l'électrode plane, une épaisseur située dans la plage comprise entre 5 et 100 µm, de manière préférée comprise entre 10 et 50 µm, de manière particulièrement préférée comprise entre 20 et 40 µm ; et/ou
vii) présente à sa surface une structuration de surface, dans lequel la structuration de surface présente de manière préférée une profondeur de structure située dans la plage comprise entre 1 nm et 100 µm, dans lequel la structuration de surface est choisie de manière particulièrement préférée dans le groupe constitué d'une structuration de surface par estampage, d'une structuration de surface par brossage, d'une structuration de surface à motifs, d'une structuration de surface striée et de combinaisons de celles-ci.

3. Procédé selon l'une quelconque des revendications précédentes, **caractérisé en ce que** la membrane de séparateur est constituée d'au moins une couche, éventuellement également d'au moins une autre couche, dans lequel la au moins une couche, éventuellement également la au moins une autre couche
i) contient ou est constituée d'un matériau électriquement isolant, dans lequel le matériau présente de manière préférée une résistivité électrique spécifique ≥ 10¹⁰ Ω.mm²/m, de manière particulièrement préférée ≥ 10¹¹ Ω.mm²/m ; et/ou
ii) contient ou est constituée d'un matériau organique, de manière préférée contient ou est constituée d'un plastique polymère, dans laquelle le plastique polymère est choisi de manière particulièrement préférée dans le groupe constitué d'une polyoléfine, d'un polymère fluoré, d'un polyamide, d'un polyimide et de combinaisons de ceux-ci, dans laquelle le plastique polymère est en particulier choisi dans le groupe constitué d'un polyéthylène, d'un polypropylène, d'un polytétrafluoroéthylène, d'un polyamide, d'un para-aramide, d'un polyimide et de combinaisons de ceux-ci ; et/ou
iii) contient ou est constituée d'un matériau inorganique, de manière préférée contient ou est constituée d'un matériau céramique, dans laquelle le matériau céramique est en particulier choisi dans le groupe constitué d'une céramique d'oxyde, d'une céramique de carbure, d'une céramique de nitrure et d'une céramique de phosphate ; et/ou
iv) présente dans une direction perpendiculaire à la surface de l'électrode plane une épaisseur située dans la plage comprise entre 1 µm et 300 µm, de manière préférée dans la plage comprise entre 1 µm et 100 µm ; et/ou
v) présente une porosité située dans la plage comprise entre 30% et 70%, de manière préférée dans la plage comprise entre 40% et 60%, et de manière particulièrement préférée dans la plage comprise entre 45% et 50%.

4. Procédé selon l'une quelconque des revendications précédentes, **caractérisé en ce que** le liquide contient un solvant qui présente, à la pression atmosphérique, un point d'ébullition ≤ 156 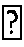 , de manière préférée ≤ 80 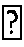 , de manière particulièrement préférée ≤ 56 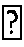 et/ou, à 20 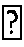 , une pression de vapeur ≥ 3 hPa, de manière préférée ≥ 58 hPa, de manière particulièrement préférée ≥ 246 hPa, dans lequel le solvant est éventuellement choisi dans le groupe constitué de l'acétone, du DEC, du DMAC, de la 3-hexanone, du THF, de la butanone, de la 3-pentanone, du toluène, du p-xylène, de l'éthanol et de mélanges de ceux-ci, dans lequel le solvant est en particulier de l'acétone.

5. Procédé selon l'une quelconque des revendications précédentes, **caractérisé en ce que** le matériau du liquide contient ou est constitué d'un polymère qui est dissous dans le solvant, dans lequel le polymère
i) contient ou est constitué de manière préférée d'un polymère non conducteur d'ions et/ou d'un polymère conducteur d'ions ; et/ou
ii) contient ou est constitué d'un fluoropolymère et/ou d'un oxyde de polyéthylène, dans lequel le fluoropolymère est de manière préférée choisi dans le groupe constitué du PVDF-HFP, du PVDF et de combinaisons de ceux-ci ; et/ou
iii) est présent dans le liquide à une concentration comprise entre 60% en poids et 80% en poids, de manière préférée comprise entre 65% en poids et 75% en poids, en particulier de 70% en poids, par rapport au poids total du liquide.

6. Procédé selon l'une quelconque des revendications précédentes, **caractérisé en ce que** le matériau du liquide contient ou est constitué de particules inorganiques qui sont dispersées dans le solvant, dans lequel les particules inorganiques sont de manière préférée
i) des particules inorganiques non conductrices d'électricité, de manière particulièrement préférée des particules céramiques non conductrices d'électricité ; et/ou
ii) des particules inorganiques conductrices d'ions, de manière particulièrement préférée des particules inorganiques conductrices d'ions qui contiennent ou sont constituées d'un sel sulfureux, dans lequel le sel sulfureux est en particulier choisi dans le groupe constitué du sulfure de lithium-phosphore, du sulfure de lithium-germanium-phosphore, du sulfure de lithium-silicium-phosphore, de Li₆PS₅Cl, de Li₆PS₅Br et de combinaisons de ceux-ci.

7. Procédé selon l'une quelconque des revendications précédentes, **caractérisé en ce que** le procédé comprend en outre, après l'étape d), l'étape consistant à :
appliquer un électrolyte liquide pour une cellule galvanique sur la deuxième surface de la membrane de séparateur, dans lequel l'électrolyte liquide pénètre par l'intermédiaire de forces capillaires au moins dans une partie des pores de la membrane de séparateur, dans l'espace entre la surface de l'électrode plane et la première surface de la membrane de séparateur et dans les pores de la surface de l'électrode plane, dans lequel l'électrolyte liquide est en contact en particulier avec la surface de l'électrode plane et la première surface de la membrane de séparateur.

8. Électrode pour une cellule galvanique, contenant ou constituée de
a) une électrode plane, dans laquelle l'électrode plane présente une surface ;
b) une membrane de séparateur qui présente une première surface, une seconde surface opposée à la première surface, et des pores, dans laquelle la première surface de la membrane de séparateur est appliquée sur la surface de l'électrode plane, et un espace est constitué entre la surface de l'électrode plane et la première surface de la membrane de séparateur;
c) un matériau choisi dans le groupe constitué par un polymère, des particules inorganiques, des particules organiques et des combinaisons de celles-ci, dans laquelle le matériau est agencé au moins dans une partie des pores de la membrane de séparateur, dans l'espace entre la surface de l'électrode plane et la première surface de la membrane de séparateur et dans les pores de la surface de l'électrode plane, et dans laquelle le matériau est en contact plan avec la première surface de la membrane de séparateur et la surface de l'électrode plane.

9. Électrode selon la revendication 8, **caractérisée en ce que** l'électrode plane
i) contient ou est constituée d'un métal alcalin, éventuellement enduit sur un métal choisi dans le groupe constitué de l'acier inoxydable, du nickel, du cuivre, de l'indium, de l'aluminium et de combinaisons de ceux-ci, dans lequel le métal alcalin est de manière préférée choisi dans le groupe constitué du lithium, du sodium et de combinaisons de ceux-ci ; et/ou
ii) contient ou est constituée de carbone, de manière préférée du carbone choisi dans le groupe constitué du graphite, du graphène et de combinaisons de ceux-ci ; et/ou
iii) contient ou est constituée de silicium, d'un alliage de silicium et/ou d'un composite à base de silicium ; et/ou
iv) contient ou est constituée d'un métal choisi dans le groupe constitué de l'acier inoxydable, du nickel, du cuivre, de l'indium, de l'aluminium, de manière préférée de l'aluminium, dans laquelle l'aluminium est éventuellement allié, de manière préférée avec au moins un élément choisi dans le II^{e} groupe principal du tableau périodique, le III^{e} groupe principal du tableau périodique, le IV^{e} groupe principal du tableau périodique, un sous-groupe du tableau périodique et des combinaisons de ceux-ci, dans laquelle au moins un élément est choisi de manière préférée dans le groupe constitué du magnésium, de l'indium, du zinc, de l'étain, du silicium, du manganèse et de combinaisons de ceux-ci ; et/ou
v) contient ou est constituée d'un matériau de cathode qui est de manière préférée choisi dans le groupe constitué de l'oxyde de nickel-manganèse-cobalt, du lithium-fer-phosphate, de l'oxyde de manganèse-lithium, de l'oxyde de nickel-manganèse-lithium, de l'oxyde de nickel-lithium, de l'oxyde de lithium-cobalt, de l'oxyde de lithium-nickel-aluminium, du phosphate de lithium-manganèse, et de combinaisons de ceux-ci ; et/ou
vi) présente dans une direction perpendiculaire à la surface de l'électrode plane, une épaisseur située dans la plage comprise entre 5 et 100 µm, de manière préférée comprise entre 10 et 50 µm, de manière particulièrement préférée comprise entre 20 et 40 µm ; et/ou
vii) présente à la surface de l'électrode plane une structuration de surface, dans laquelle la structuration de surface présente de manière préférée une profondeur de structure située dans la plage comprise entre 1 nm et 100 µm, dans laquelle la structuration de surface est choisie de manière particulièrement préférée dans le groupe constitué d'une structuration de surface par estampage, d'une structuration de surface par brossage, d'une structuration de surface à motifs, d'une structuration de surface striée et de combinaisons de celles-ci.

10. Électrode selon l'une quelconque des revendications 8 ou 9, **caractérisée en ce que** la membrane de séparateur est constituée d'au moins une couche, éventuellement également d'au moins une autre couche, dans laquelle la au moins une couche, éventuellement également la au moins une autre couche,
i) contient ou est constituée d'un matériau électriquement isolant, dans lequel le matériau présente de manière préférée une résistivité électrique spécifique ≥ 10¹⁰ Ω.mm²/m, de manière particulièrement préférée ≥ 10¹¹ Ω.mm²/m ; et/ou
ii) contient ou est constituée d'un matériau organique, de manière préférée contient ou est constituée d'un plastique polymère, dans laquelle le plastique polymère est choisi de manière particulièrement préférée dans le groupe constitué d'une polyoléfine, d'un polymère fluoré, d'un polyamide, d'un polyimide et de combinaisons de ceux-ci, dans laquelle le plastique polymère est en particulier choisi dans le groupe constitué d'un polyéthylène, d'un polypropylène, d'un polytétrafluoroéthylène, d'un polyamide, d'un para-aramide, d'un polyimide et de combinaisons de ceux-ci ; et/ou
iii) contient ou est constituée d'un matériau inorganique, de manière préférée contient ou est constituée d'un matériau céramique, dans laquelle le matériau céramique est en particulier choisi dans le groupe constitué d'une céramique d'oxyde, d'une céramique de carbure, d'une céramique de nitrure et d'une céramique de phosphate ; et/ou
iv) présente dans une direction perpendiculaire à la surface de l'électrode plane une épaisseur située dans la plage comprise entre 1 µm et 300 µm, de manière préférée dans la plage comprise entre 1 µm et 100 µm ; et/ou
v) présente une porosité située dans la plage comprise entre 30% et 70%, de manière préférée dans la plage comprise entre 40% et 60%, et de manière particulièrement préférée dans la plage comprise entre 45% et 50%.

11. Électrode selon l'une quelconque des revendications 8 à 10, **caractérisée en ce que** le matériau, qui est agencé au moins dans une partie des pores de la membrane de séparateur, dans l'espace entre la surface de l'électrode plane et la première surface de la membrane de séparateur et dans les pores de la surface de l'électrode plane, contient un polymère ou est constitué d'un polymère, dans laquelle le polymère
i) contient ou est constitué de manière préférée d'un polymère non conducteur d'ions et/ou d'un polymère conducteur d'ions ; et/ou
ii) contient ou est constitué d'un fluoropolymère et/ou d'un oxyde de polyéthylène, dans laquelle le fluoropolymère est de manière préférée choisi dans le groupe constitué du PVDF-HFP, du PVDF et de combinaisons de ceux-ci.

12. Électrode selon l'une quelconque des revendications 8 à 11, **caractérisée en ce que** le matériau, qui est agencé au moins dans une partie des pores de la membrane de séparateur, dans l'espace entre la surface de l'électrode plane et la première surface de la membrane de séparateur et dans les pores de la surface de l'électrode plane, contient ou est constitué de particules inorganiques, dans laquelle les particules inorganiques sont
i) des particules inorganiques non conductrices d'électricité, de manière particulièrement préférée des particules céramiques non conductrices d'électricité ; et/ou
ii) des particules inorganiques conductrices d'ions, de manière particulièrement préférée des particules inorganiques conductrices d'ions qui contiennent ou sont constituées d'un sel sulfureux, dans lequel le sel sulfureux est en particulier choisi dans le groupe constitué du sulfure de lithium-phosphore, du sulfure de lithium-germanium-phosphore, du sulfure de lithium-silicium-phosphore, de Li₆PS₅Cl, de Li₆PS₅Br et de combinaisons de ceux-ci.

13. Électrode selon l'une quelconque des revendications 8 à 12, **caractérisée en ce qu'**un électrolyte liquide est agencé au moins dans une partie des pores de la membrane de séparateur, dans l'espace entre la surface de l'électrode plane et la première surface de la membrane de séparateur et dans les pores de la surface de l'électrode plane, dans laquelle l'électrolyte liquide est en contact en particulier avec la surface de l'électrode plane et la première surface de la membrane de séparateur.

14. Cellule galvanique, contenant une électrode selon l'une quelconque des revendications 8 à 13, une contre-électrode et un électrolyte.

15. Utilisation de la cellule galvanique selon la revendication 14 pour l'alimentation en énergie
i) d'un dispositif mobile, de manière préférée d'un téléphone portable, d'un véhicule, d'un avion et/ou d'un navire ; et/ou
ii) d'un dispositif stationnaire, de manière préférée d'un bâtiment.
